(19) Europäisches Patentamt

European Patent Office

Office européen des brevets

(11) EP 1 755 211 B1

## (12) EUROPEAN PATENT SPECIFICATION

(45) Date of publication and mention
of the grant of the patent:
**09.04.2008 Bulletin 2008/15**

(51) Int Cl.:
*H02P 21/14* (2006.01)          *H02P 23/14* (2006.01)

(21) Application number: **05107612.3**

(22) Date of filing: **19.08.2005**

(54) **Resistance estimation of an AC electrical motor**

Widerstandsschätzung eines elektrischen Wechselstrommotors

Estimation de resistance d'un moteur électric à courant alternatif

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**21.02.2007 Bulletin 2007/08**

(73) Proprietor: **ABB Oy
00380 Helsinki (FI)**

(72) Inventor: **Vertanen, Mikko
02660, Espoo (FI)**

(74) Representative: **Valkeiskangas, Tapio Lassi
Paavali
Kolster Oy Ab
Iso Roobertinkatu 23, P.O. Box 148
00121 Helsinki (FI)**

(56) References cited:
**DE-A1- 19 524 654**

- **DATABASE INSPEC [Online] THE INSTITUTION
  OF ELECTRICAL ENGINEERS, STEVENAGE, GB;
  4 December 2003 (2003-12-04), VASIC V ET AL:
  "A stator resistance estimation scheme for speed
  sensorless rotor flux oriented induction motor
  drives" XP002361108 Database accession no.
  7820600 -& IEEE Transactions on Energy
  Conversion IEEE USA, vol. 18, no. 4, 4 December
  2003 (2003-12-04), pages 476-483, XP002361104
  ISSN: 0885-8969**
- **DATABASE INSPEC [Online] THE INSTITUTION
  OF ELECTRICAL ENGINEERS, STEVENAGE, GB;
  4 August 2000 (2000-08-04), IN-JOONG HA ET AL:
  "An online identification method for both stator-
  and rotor resistances of induction motors
  without rotational transducers" XP002361109
  Database accession no. 6685870 -& IEEE
  Transactions on Industrial Electronics IEEE USA,
  vol. 47, no. 4, 4 August 2000 (2000-08-04), pages
  842-853, XP002361105 ISSN: 0278-0046**

## Description

BACKGROUND OF THE INVENTION

The invention relates to a method for estimating stator resistance of an AC electrical machine. More specifically, the invention relates to a method which can be used for estimating stator resistance during operation of an AC electrical machine. The estimated stator resistance can be further used as a basis for estimating rotor resistance, if such exists.

In modern frequency converters, which are used for controlling an AC electrical machine, the accuracy of control is based on estimated, rather than directly measured, parameters. These parameters are estimated because measurement is impossible in practice. The direct measurement of for example stator resistance is possible when the machine is not running. Once the machine is running the measurement is not, however, that simple. Further, the measurement result for a cold machine differs considerably from a result obtained from a warmed-up machine. Thus, a pure off-line measurement with no compensations for taking into account the warming of the machine results errors, which can be seen in the accuracy and stability of the control.

There is a plurality of identification methods suitable for use in connection with induction machines known in the art. These methods include I.-J. Ha, S.-H. Lee, "An Online Identification method for both Stator and Rotor Resistances of Induction Motors without Rotational Transducers", IEEE Transactions on Industrial Electronics, Vol. 47, No. 4, August 2000, pp. 842 to 853 and V. Vasic' , S N. Vukosavic, E. Levi, "A stator resistance estimation scheme for speed sensorless rotor flux oriented induction motor drives", IEEE Trans. Energy Conversion, vol 18, no. 4, December 2003.

The above identification methods are suitable only for identification of parameters of an induction machine. A need for identification of the parameters is also present in the case of another type of AC electrical machines, such as permanent magnet synchronous machines.

Document Novotny D. W., Lipo T. A. (1997), "Vector Control and Dynamics of AC Drives", New York, USA, Oxford University Press discloses the features of the preamble of claim 1, although not in connection with resistance estimation.

BRIEF DESCRIPTION OF THE INVENTION

It is an object of the present invention to provide an alternative method for estimating accurately stator resistance of an AC electrical machine, the method being further suitable for use in connection with both an induction machine and a permanent magnet synchronous machine.

This object is achieved by a method of the invention, which is characterized by what is stated in independent claim 1.

The invention is based on the idea that a commonly used voltage model is stabilized by using an error quantity which is proportional to the difference between two different rotor flux amplitudes. This error quantity is further used for defining a voltage correction vector, which is added to the known voltage model of the AC electrical machine. The same voltage correction vector is also used for estimating stator resistance.

The above-mentioned commonly used voltage model is disclosed for example in Hinkkanen M. (2004) "Flux estimators for speed-sensorfess induction motor drives". Ph.D. thesis, Dept. Elect. Commun. Eng., Helsinki University of Technology, Espoo, Finland.

The method of the invention provides an accurate estimation method for estimating stator resistance of an AC induction machine, including both an induction machine and a PMSM. Further, the method of the invention involves no measured speed or position, so it can be applied both to sensorless drives (i.e. without speed or position measurement) and drives with sensors (i.e. with speed or position measurement).

BRIEF DESCRIPTION OF THE FIGURE

The invention will be described in more detail by means of preferred embodiments and with reference to the attached drawings, in which

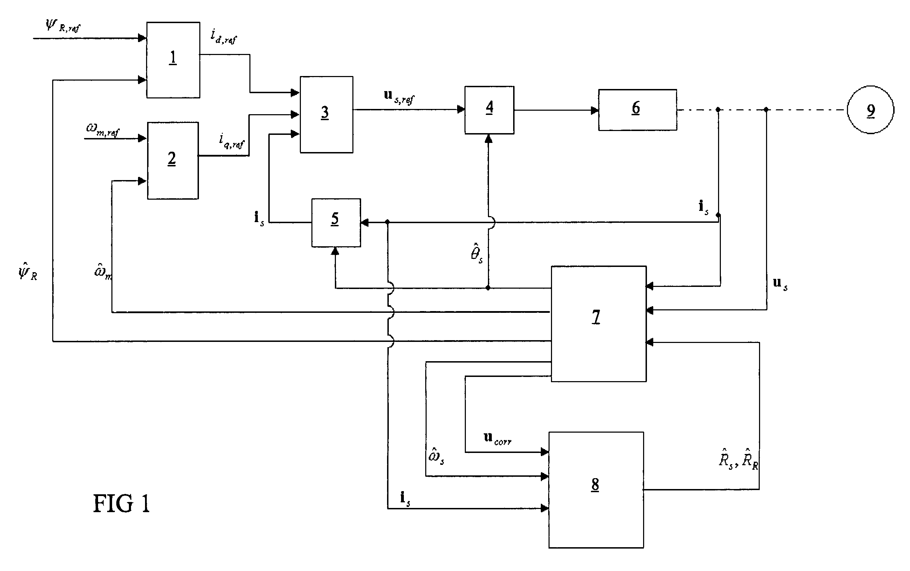

Figure 1 is a block diagram illustrating a use of a method of the invention in connection with vector control of an asynchronous motor.

DETAILED DESCRIPTION OF THE INVENTION

For an asynchronous, i.e. induction, machine an L equivalent (or inverse r equivalent) circuit is employed. A dynamic model of a permanent magnet synchronous machine is much simpler, since no rotor windings are used. Thus the PMSM has no rotor resistance. If a rotor of the PMSM is non-salient, the stator inductance is constant around the entire airgap. With a salient rotor, the stator inductance of the PMSM varies as a function of a rotor flux angle and it has to be taken into account in the model.

Stator circuits of the asynchronous and PMS machines are identical. The method is based on a voltage model, which is known in the art and presented here in stator reference frame

$$\dot{\hat{\psi}}_s = \mathbf{u}_s - \hat{R}_s \mathbf{i}_s \, , \qquad\qquad (1)$$

where $\hat{\psi}_s$ is a stator flux vector estimate, $\mathbf{u}_s$ is a stator voltage vector, $\mathbf{i}_s$ is a stator current vector and $\hat{R}_s$ is stator resistance estimate. At the outset of the present method, a proper initial value for stator resistance is to be given.

The voltage model is similar for different AC machines. A stator flux can be estimated using this voltage model. Rotor flux $\hat{\psi}_R$, or a quantity proportional to such a rotor flux, can be calculated from the voltage model by using equation

$$\hat{\psi}_R = \hat{\psi}_s - \hat{L}_\sigma \mathbf{i}_s \, , \qquad\qquad (2)$$

where $\hat{L}_\sigma$ is a total leakage (transient) inductance estimate of the asynchronous motor or a stator inductance estimate of the permanent magnet synchronous motor. However, this equation is valid only when the motor is symmetric and the inductance is constant. This is typical for asynchronous motors. Synchronous motors are often asymmetric and inductances, corresponding estimates denoted as $\hat{L}_{\sigma d}, \hat{L}_{\sigma q}$, are different in directions d and q. Therefore, equation (2) should be calculated in a rotor flux reference frame. A stator flux expressed in a rotor flux co-ordinate system is

$$\hat{\psi}_s^{dq} = \hat{\psi}_s^{xy} e^{-j\hat{\theta}_s} \, . \qquad\qquad (3)$$

In a component form equation (3) becomes

$$\hat{\psi}_{sd} = \mathrm{Re}\left\{ e^{-j\hat{\theta}_s} \hat{\psi}_s^{xy} \right\} = \hat{\psi}_{sx} \cos\hat{\theta}_s + \hat{\psi}_{sy} \sin\hat{\theta}_s$$
$$\hat{\psi}_{sq} = \mathrm{Im}\left\{ e^{-j\hat{\theta}_s} \hat{\psi}_s^{xy} \right\} = \hat{\psi}_{sy} \cos\hat{\theta}_s - \hat{\psi}_{sx} \sin\hat{\theta}_s \, , \qquad\qquad (4)$$

and for current similarly in component form

$$\hat{i}_{sd} = \mathrm{Re}\left\{ e^{-j\hat{\theta}_s} \mathbf{i}_s^{xy} \right\} = i_{sx} \cos\hat{\theta}_s + i_{sy} \sin\hat{\theta}_s$$
$$\hat{i}_{sq} = \mathrm{Im}\left\{ e^{-j\hat{\theta}_s} \mathbf{i}_s^{xy} \right\} = i_{sy} \cos\hat{\theta}_s - i_{sx} \sin\hat{\theta}_s \, . \qquad\qquad (5)$$

In the rotor flux reference frame equation (2) can be rewritten in a component form as

$$\hat{\psi}_{Rd} = \hat{\psi}_{sd} - \hat{L}_{\sigma d} \hat{i}_{sd}$$
$$\hat{\psi}_{Rq} = \hat{\psi}_{sq} - \hat{L}_{\sigma q} \hat{i}_{sq} \, , \qquad\qquad (6)$$

which is then transformed back to a stator reference frame:

$$\hat{\psi}_{Rx} = \mathrm{Re}\left\{e^{j\hat{\theta}_s}\hat{\psi}_R^{dq}\right\} = \hat{\psi}_{Rd}\cos\hat{\theta}_s - \hat{\psi}_{Rq}\sin\hat{\theta}_s$$
$$\hat{\psi}_{Ry} = \mathrm{Im}\left\{e^{j\hat{\theta}_s}\hat{\psi}_R^{dq}\right\} = \hat{\psi}_{Rq}\cos\hat{\theta}_s + \hat{\psi}_{Rd}\sin\hat{\theta}_s \quad\quad (7)$$

Ways other than equations (4) to (7) also exist for calculating a voltage model based rotor flux. When the motor is symmetrical, as in the case of asynchronous machines, the calculation can be carried out in a stator reference frame using equation (2). An angle of the rotor flux can be estimated straight forwardly by using equation

$$\hat{\theta}_s = \arctan\left(\frac{\hat{\psi}_{Ry}}{\hat{\psi}_{Rx}}\right). \quad\quad (8)$$

A plurality of other known ways for estimating the rotor flux angle exists. For example certain kinds of phase locked loop systems can be used for the purpose.

According to the method of the invention, an error quantity is introduced

$$\varepsilon = \hat{\psi}_{Rc} - \hat{\psi}_{Rd}, \quad\quad (9)$$

where $\hat{\psi}_{Rc}$ is a rotor flux amplitude independent of motor resistances. Determination of $\hat{\psi}_{Rc}$ depends on the motor type. For a permanent magnet synchronous machine this is a simple task:

$$\hat{\psi}_{Rc} = \hat{\psi}_{R,pm}, \quad\quad (10)$$

where $\hat{\psi}_{R,pm}$ is the flux of the permanent magnet. This flux can be quite easily identified during the commissioning of the drive, and the value is rather constant and predictable. For an asynchronous machine a current model is used. The current model is also well known in the art, and for a rotor flux amplitude the current model gives

$$\dot{\hat{\psi}}_{Rc} = \hat{R}_R \hat{i}_{sd} - \frac{1}{\hat{\tau}_r}\hat{\psi}_{Rc} = \frac{1}{\hat{\tau}_r}\left(\hat{L}_M \hat{i}_{sd} - \hat{\psi}_{Rc}\right), \quad\quad (11)$$

where $\hat{R}_R$ is the rotor resistance estimate (according to an L equivalent circuit), $\hat{\tau}_r = \hat{L}_M/\hat{R}_R$ is the rotor time constant estimate and $\hat{L}_M$ is the main inductance estimate (according to an L equivalent circuit). A current d component is, naturally, calculated by using the latest flux angle obtained from equation (8). It can be seen from equation (11) that it does not depend on the rotor resistance in a steady state.

Because of the integration nature of voltage model equation (1), in order to obtain a usable stator flux estimate for any task, an additional stabilizing feedback is needed. This can be achieved according to the method of the invention by using the error term of equation (9). The stabilizing feedback is defined as a following voltage correction, which is added to voltage model equation (1):

$$\mathbf{u}_{corr} = u_{x,corr} + ju_{y,corr} = \mathbf{K}_c \varepsilon\, e^{j\hat{\theta}_s}, \quad\quad (12)$$

where a tuning gain vector is

$$\mathbf{K}_c = k_c e^{j\gamma},\qquad(13)$$

where $k_c$ is scalar tuning gain. Term $e^{j\hat{\theta}}$ is used in equation (12) to convert the voltage correction vector to the same co-ordinate system as the voltage model, i.e. to the stationary co-ordinate system.

Correction angle $\gamma$ is preferably defined as

$$\gamma = \begin{cases} \gamma_{max}\, \mathrm{sgn}(\hat{\omega}_s)\cdot\left(1-\dfrac{|\hat{\omega}_s|}{\omega_N}\right), & |\hat{\omega}_s| \le \omega_N \\ 0, & |\hat{\omega}_s| > \omega_N \end{cases},\qquad(14)$$

where $\hat{\omega}_s$ is an electrical frequency estimate and $\omega_N$ is a nominal electrical frequency of the motor and advantageously

$$\begin{cases} \gamma_{max} > 40^0, & \hat{\omega}_s \hat{i}_{sq} < 0 \\ \gamma_{max} < 40^0, & \hat{\omega}_s \hat{i}_{sq} \ge 0 \end{cases},$$

depending on the type of the motor. Voltage correction vector (12) is simply added to equation (1), thus the corrected voltage model becomes

$$\dot{\hat{\boldsymbol{\psi}}}_s = \mathbf{u}_s - \hat{R}_s \mathbf{i}_s + \mathbf{u}_{corr}.\qquad(15)$$

Both expressions (10) and (11) are independent of the resistances. According to the method of the invention, the stator resistance is estimated online by using an adaptation mechanism.

This adaptation mechanism requires two new error terms, as a function of stator current and voltage correction. According to the method of the invention, the first resistance adaptation error term is defined as

$$P_{err} = -\mathbf{u}_{corr}\cdot\mathbf{i}_s = -u_{x,corr}i_x - u_{y,corr}i_y = -u_{d,corr}\hat{i}_d - u_{q,corr}\hat{i}_q,\qquad(16)$$

and the second resistance adaptation term as

$$Q_{err} = -\mathbf{u}_{corr}\times\mathbf{i}_s = -u_{x,corr}i_y + u_{y,corr}i_x = -u_{d,corr}\hat{i}_q + u_{q,corr}\hat{i}_d.\qquad(17)$$

As seen above, both equations (16) and (17) can be calculated by using either xy- or dq-components, i.e. the co-ordinate system used can be a stator co-ordinate system or a synchronous co-ordinate system.

According to the invention, the stator resistance estimate $\hat{R}_s$ is determined by using a first resistance adaptation error term $P_{err}$ in a PI adaptation mechanism when the absolute value of the electrical frequency $\omega_s$ of the AC electrical machine is lower than the frequency limit $\omega_{pq,lim}$. If the electrical frequency $\omega_s$ of the AC electrical machine is equal to or higher than the frequency limit $\omega_{pq,lim}$, the resistance estimate $\hat{R}_s$ is determined by using a second resistance adaptation error term $Q_{err}$ in a PI adaptation mechanism. The determination of the stator resistance estimate can be expressed as

$$\hat{R}_s = \begin{cases} k_p\, Q_{err}\, \text{sgn}(\omega_s) + k_i \int\limits_{\Delta T} Q_{err}\, \text{sgn}(\omega_s)dt, & |\omega_s| \geq \omega_{pq,\lim} \\ k_p\, P_{err} + k_i \int\limits_{\Delta T} P_{err}dt, & |\omega_s| < \omega_{pq,\lim} \end{cases}, \qquad (18)$$

where $k_p, k_i$ are a controller's tuning gains and an advantageous frequency limit can be $0 < \omega_{pq,\lim} < 4$ Hz , depending on the motor type. It can be seen from equation (18) that the adaptation mechanism is a PI controller type adaptation, which controls the error to zero. Thus $P_{err}$ and respectively $Q_{err}$ are controlled to zero by changing the value of the estimated stator resistance in the system. When $P_{err}$ or $Q_{err}$ are controlled to zero, also $\mathbf{u}_{corr}$ is zero since according to equations (16) and (17), $P_{err}$ or $Q_{err}$ can be zero only when either $\mathbf{u}_{corr}$ is zero or the stator current is zero. This further means that the estimated stator resistance has a correct value when rotor flux amplitude $\hat{\psi}_{Rc}$ is correct.

Equation (18) also takes into account the sign of the electrical frequency of the machine when the resistance is estimated from the second resistance adaptation error term $Q_{err}$.

As mentioned above, initial values for stator and rotor resistances, denoted as $\hat{R}_{s0}, \hat{R}_{R0}$, are defined for example for a cold machine during the commissioning of the drive. These values can be used before the method of invention has provided any estimates, i.e. during the start-up of the drive. Both the stator and the rotor resistance change as a function of the motor temperature, and the relative rate of the change can be assumed to be about the same for both. Rotor resistance can thus be defined as a scaled and low pass filtered value of stator resistance

$$\dot{\hat{R}}_R = \frac{1}{\tau_{Rf}} \left( \frac{\hat{R}_{R0}}{\hat{R}_{s0}} \hat{R}_s - \hat{R}_R \right), \qquad (19)$$

where $\tau_{Rf}$ is a time constant of the low pass filter. Estimated stator and rotor resistances are used in equations (11) and (15). They can also be used simultaneously in some other model, e.g. a motor model with encoder feedback or speed estimation. It should also be noted that rotor resistance can be estimated in any other way than described in equation (19).

The above equations are used in the method in a recursive way. It should also be noted that the above-presented equations can be transformed to any other reference frame, such as a synchronous reference frame, and most of the calculations can also be carried out in such other reference frame. Only minor changes, which are clear to a skilled person, are needed in the equations due to the change of the co-ordinate system.

In the following, the method of the invention will be described in connection with Figure 1, which shows an example of a control system which uses a method of the invention. Figure 1 shows a control system, in which a rotor flux and the speed of a machine 9 is controlled. The system includes a flux controller 1 and a speed controller 2. The flux controller 1 receives a reference value for rotor flux $\hat{\psi}_{R,ref}$ and rotor flux estimate $\hat{\psi}_R$ as its inputs. The speed controller 2 receives mechanical speed reference $\omega_{m,ref}$ and estimated mechanical speed $\hat{\omega}_m$ at its inputs.

The flux controller 1 outputs a reference value for direct axis current component $i_{d,ref}$ and the speed controller 2 outputs a reference value for quadrature axis current component $i_{q,ref}$. The control is thus carried out in a synchronous or a dq-reference frame. These currents are fed to a current controller 3 which also receives measured current vector $\mathbf{i}_s$ as feedback. Since the reference values for currents are in the dq-reference frame, the measured current is also transformed to same co-ordinate system by using a co-ordinate transformation block 5. The block 5 receives an estimated angle of the rotor flux $\hat{\theta}_s$, by which the current vector $\mathbf{i}_s$ is rotated.

The current controller 3 outputs stator voltage reference vector $\mathbf{u}_{s,ref}$, which is transformed back to a stationary co-ordinate system by using a co-ordinate transformation block 4, which receives the same angle $\hat{\theta}_s$ as the block 5 and rotates voltage reference vector $\mathbf{u}_{s,ref}$. This rotated voltage vector is then used as a reference value for an inverter 6, which controls its output voltage to be that of the reference. The output voltage of the inverter further drives the machine 9, which in this case is an induction motor.

As mentioned above, the output current of the inverter 6 or machine stator current is is measured. The output voltage or stator voltage $\mathbf{u}_s$ is also measured or determined based on the DC voltage measurement and the i n-verter's switch position. These vectors are fed to a flux, frequency and speed estimation block 7. This block 7 calculates an estimated angle of rotor flux $\hat{\theta}_s$, and outputs it to the co-ordinate transformation blocks 4 and 5. Further, in block 7, the mechanical speed of the controlled motor is estimated, and this estimated value $\hat{\omega}_m$ is outputted to the speed controller 2 as its feedback. Rotor flux estimate $\hat{\psi}_R$ is also estimated in the block 7, and this estimate is fed to the flux controller 1 as its feedback.

The block 7 also calculates voltage correction vector $\mathbf{u}_{corr}$ and electrical frequency $\hat{\omega}_s$ of the controlled motor. Both these values are fed to a resistance estimation block 8. The block 8 also receives measured current vector $\mathbf{i}_s$ as its input. From these values, stator resistance estimate $\hat{R}_s$ is calculated as explained above by using the method of the invention. Further, also rotor resistance estimate $\hat{R}_R$ is calculated. This can be carried out for example by using equation (19). The resistance estimates are fed to the block 7, which uses these estimates for its own calculations.

It is to be understood that the method of the invention can be used in connection with different control systems and not only with the one described in Figure 1. The estimated stator resistance achieved with the method of the invention can also be used in parallel systems for identification of some other parameter. Also, the block structure shown in Figure 1 is merely an example. It is obvious that the division into the illustrated blocks is provided only to visualize the functioning of the invention.

It is obvious to a person skilled in the art that as technology advances, the basic idea of the invention can be implemented in many different ways. The invention and its embodiments are thus not restricted to the examples described above, but can vary within the scope of the claims.

**Claims**

**1.** A method for estimating stator resistance of an AC electrical machine, the method comprising the steps of

determining a stator current vector ($\mathbf{i}_s$) of the AC electrical machine,

determining a stator voltage vector ($\mathbf{u}_s$) of the AC electrical machine,

defining a voltage model for the AC electrical machine, which links a stator flux ($\psi_s$), a stator current ($\mathbf{i}_s$) and a stator voltage ($\mathbf{u}_s$) together, and

determining a stator flux estimate ($\hat{\psi}_s$) by using said voltage model of the AC electrical machine, **characterized by** the method comprising the steps of

determining a first rotor flux amplitude estimate ($\hat{\psi}_{Rc}$) which is independent of the resistances of the AC machine,

determining a second rotor flux amplitude estimate ($\hat{\psi}_{Rd}$) from said stator flux estimate ($\hat{\psi}_s$),

defining an error quantity ($\varepsilon$) as a difference between said first rotor flux amplitude estimate and said second rotor flux amplitude estimate ($\varepsilon = \hat{\psi}_{Rc} - \hat{\psi}_{Rd}$),

defining a voltage correction term ($\mathbf{u}_{corr}$) as a product of said error quantity ($\varepsilon$) and a tuning gain vector ($\mathbf{K}_c$) having an amplitude ($k_c$) and a direction ($\gamma$),

adding the voltage correction term ($\mathbf{u}_{corr}$) to said voltage model of the AC electrical machine to stabilize said stator flux estimate ($\hat{\psi}_s$),

defining a first resistance adaptation error term ($P_{err}$) as a scalar product between a negation of said voltage correction term (-$\mathbf{u}_{corr}$) and said stator current vector ($\mathbf{i}_s$) ($P_{err} = -\mathbf{u}_{corr} \cdot \mathbf{i}_s$),

defining a second resistance adaptation error term ($Q_{err}$) as a cross product between the negation of said voltage correction term (-$\mathbf{u}_{corr}$) and said stator current vector ($\mathbf{i}_s$)($Q_{err} = -\mathbf{u}_{corr} \times \mathbf{i}_s$),

defining a frequency limit ($\omega_{pq,lim}$),

determining a stator resistance estimate ($\hat{R}_s$) by using said first resistance adaptation error term ($P_{err}$) in a PI adaptation mechanism when an absolute value of electrical frequency ($\omega_s$) of the AC electrical machine is lower than said frequency limit ($\omega_{pq,lim}$),

and determining the stator resistance estimate ($\hat{R}_s$) by using said second resistance adaptation error term ($Q_{err}$) in a PI adaptation mechanism when the absolute value of said electrical frequency ($\omega_s$) of the AC electrical machine is equal to or higher than said frequency limit ($\omega_{pq,lim}$).

**2.** A method according to claim 1, **characterized in that** the determination of the first rotor flux amplitude estimate ($\hat{\psi}_{Rc}$) which is independent of the resistances of the AC machine comprises a step in connection with a permanent synchronous machine, where the first rotor flux amplitude estimate is set to be the flux ($\hat{\psi}_{R,pm}$) of a permanent magnet of the synchronous machine.

**3.** A method according to claim 1, **characterized in that** the determination of the first rotor flux amplitude estimate ($\hat{\psi}_{Rc}$) which is independent of the resistances of the AC machine comprises a step in which the first rotor flux amplitude estimate is calculated using a current model of the machine.

**4.** A method according to claim 1, 2 or 3, **characterized in that** a direction ($\gamma$) of the tuning gain vector ($\mathbf{K}_c$) is selected based on an electrical frequency estimate ($\hat{\omega}_s$) of the machine such that

$$\gamma = \begin{cases} \gamma_{\max}\, \mathrm{sgn}(\hat{\omega}_s) \cdot \left(1 - \dfrac{|\hat{\omega}_s|}{\omega_N}\right), & |\hat{\omega}_s| \le \omega_N \\[2mm] 0, & |\hat{\omega}_s| > \omega_N \end{cases},$$

where $\omega_N$ is nominal electrical frequency of the machine and

$$\begin{cases} \gamma_{\max} > 40^0, & \hat{\omega}_s \hat{i}_{sq} < 0 \\[2mm] \gamma_{\max} < 40^0, & \hat{\omega}_s \hat{i}_{sq} \ge 0 \end{cases},$$

where $\hat{i}_{sq}$ is an estimate of a quadrature axis component stator current.

**Patentansprüche**

1. Verfahren zum Schätzen von Statorwiderstand einer elektrischen Wechselstrommaschine, wobei das Verfahren die folgenden Schritte umfasst:

   Bestimmen eines Statorstromvektors ($\mathbf{i}_s$) der elektrischen Wechselstrommaschine,
   Bestimmen eines Statorspannungsvektors ($\mathbf{u}_s$) der elektrischen Wechselstrommaschine,
   Definieren eines Spannungsmodells für die elektrische Wechselstrommaschine, das einen Statorfluss ($\psi_s$), einen Statorstrom ($\mathbf{i}_s$) und eine Statorspannung ($\mathbf{u}_s$) miteinander verknüpft, und
   Bestimmen einer Statorflussschätzung ($\hat{\psi}_s$) unter Verwendung des Spannungsmodells der elektrischen Wechselstrommaschine, **dadurch gekennzeichnet, dass** das Verfahren die folgenden Schritte umfasst:

   Bestimmen einer ersten Läuferflussamplitudenschätzung ($\hat{\psi}_{Rc}$), die von den Widerständen der Wechselstrommaschine unabhängig ist,
   Bestimmen einer zweiten Läuferflussamplitudenschätzung ($\hat{\psi}_{Rd}$) anhand der Statorflussschätzung ($\hat{\psi}_s$),
   Definieren einer Fehlermenge (s) als eine Differenz zwischen der ersten Läuferflussamplitudenschätzung und der zweiten Läuferflussamplitudenschätzung ($\varepsilon = \hat{\psi}_{Rc} - \hat{\psi}_{Rd}$),
   Definieren eines Spannungskorrekturterms ($\mathbf{u}_{corr}$) als ein Produkt aus der Fehlermenge (s) und einem Abstimmungsverstärkungsvektor ($\mathbf{K}_c$) mit einer Amplitude ($k_c$) und einer Richtung ($\gamma$),
   Addieren des Spannungskorrekturterms ($\mathbf{u}_{corr}$) zu dem Spannungsmodell der elektrischen Wechselstrommaschine, um die Statorflussschätzung ($\hat{\psi}_s$) zu stabilisieren,
   Definieren eines ersten Widerstandsadaptationsfehlerterms ($P_{err}$) als ein Skalarprodukt zwischen einer Negation des Spannungskorrekturterms ($-\mathbf{u}_{corr}$) und dem Statorstromvektor ($\mathbf{i}_s$) ($P_{err} = -\mathbf{u}_{corr} \cdot \mathbf{i}_s$),
   Definieren eines zweiten Widerstandsadaptationsfehlerterms ($Q_{err}$) als ein Kreuzprodukt zwischen der Negation des Spannungskorrekturterms ($-\mathbf{u}_{corr}$) und dem Statorstromvektor ($\mathbf{i}_s$) ($Q_{err} = -\mathbf{u}_{corr} \times \mathbf{i}_s$)
   Definieren einer Frequenzgrenze ($\omega_{pq,lim}$),
   Bestimmen einer Statorwiderstandsschätzung ($\hat{R}_s$) unter Verwendung des ersten Widerstandsadaptationsfehlerterms ($P_{err}$) in einem PI-Adaptationsmechanismus, wenn ein Absolutwert elektrischer Frequenz ($\omega_s$) der elektrischen Wechselstrommaschine niedriger ist als die Frequenzgrenze ($\omega_{pq,lim}$),
   und Bestimmen der Statorwiderstandsschätzung ($\hat{R}_s$) unter Verwendung des zweiten Widerstandsadaptationsfehlerterms ($Q_{err}$) in einem PI-Adaptationsmechanismus, wenn der Absolutwert der elektrischen Frequenz ($\omega_s$) der elektrischen Wechselstrommaschine der Frequenzgrenze ($\omega_{pq,lim}$) entspricht oder höher als diese ist.

2. Verfahren nach Anspruch 1, **dadurch gekennzeichnet, dass** die Bestimmung der ersten Läuferflussamplitudenschätzung ($\hat{\psi}_{Rc}$), die von den Widerständen der Wechselstrommaschine unabhängig ist, einen Schritt in Verbindung mit einer Dauersynchronmaschine umfasst, wobei die erste Läuferflussamplitudenschätzung so eingestellt ist, dass sie der Fluss ($\hat{\psi}_{R,pm}$) eines Dauermagneten der Synchronmaschine ist.

3. Verfahren nach Anspruch 1, **dadurch gekennzeichnet, dass** die Bestimmung der ersten Läuferflussamplitudenschätzung ($\hat{\psi}_{Rc}$), die von den Widerständen der Wechselstrommaschine unabhängig ist, einen Schritt umfasst, bei dem die erste Läuferflussamplitudenschätzung unter Verwendung eines Strommodells der Maschine berechnet wird.

4. Verfahren nach Anspruch 1, 2 oder 3, **dadurch gekennzeichnet, dass** eine Richtung ($\gamma$) des Abstimmungsverstärkungsvektors ($K_c$) auf Basis einer Schätzung elektrischer Frequenz ($\hat{\omega}_s$) der Maschine so gewählt wird, dass

$$\gamma = \left\{ \begin{array}{ll} \gamma_{max} \, \text{sgn}(\hat{\omega}_s) \cdot \left(1 - \dfrac{|\hat{\omega}_s|}{\omega_N}\right), & |\hat{\omega}_s| \leq \omega_N \\ 0, & |\hat{\omega}_s| > \omega_N \end{array} \right. ,$$

wobei $\omega_N$ die elektrische Nennfrequenz der Maschine ist, und

$$\left\{ \begin{array}{ll} \gamma_{max} > 40^0, & \hat{\omega}_s \hat{i}_{sq} < 0 \\ \gamma_{max} < 40^0, & \hat{\omega}_s \hat{i}_{sq} \geq 0 \end{array} \right. ,$$

wobei $\hat{i}_{sq}$ eine Schätzung eines Querfeldkomponenten-Statorstroms ist.

## Revendications

1. Procédé pour estimer la résistance du stator d'une machine électrique à courant alternatif, le procédé comprenant les étapes consistant à :

   déterminer un vecteur de courant de stator ($i_s$) de la machine électrique à courant alternatif ;
   déterminer un vecteur de tension de stator ($u_s$) de la machine électrique à courant alternatif ;
   définir un modèle de tension pour la machine électrique à courant alternatif, lequel relie ensemble un flux de stator ($\psi s$), un courant de stator ($i_s$) et une tension de stator ($u_s$) ; et
   déterminer une estimation du flux du stator ($\hat{\psi}_s$) à l'aide dudit modèle de tension de la machine électrique à courant alternatif, **caractérisé en ce que** le procédé comprend les étapes consistant à :

   déterminer une première estimation de l'amplitude du flux du rotor ($\hat{\psi}_{Rc}$) qui est indépendante des résistances de la machine à courant alternatif ;
   déterminer une seconde estimation de l'amplitude du flux du rotor ($\hat{\psi}_{Rd}$) à partir de ladite estimation du flux du stator $\hat{\psi}_s$ ;
   définir une quantité d'erreur ($\varepsilon$) comme différence entre ladite première estimation de l'amplitude du flux du rotor et ladite seconde estimation de l'amplitude du flux du rotor ($\varepsilon = \hat{\psi}_{Rc} - \hat{\psi}_{Rd}$) ;
   définir un terme de correction de tension ($u_{corr}$) comme produit de ladite quantité d'erreur ($\varepsilon$) et d'un vecteur de gain d'accord ($K_c$) ayant une amplitude ($k_c$) et une direction ($\gamma$) ;
   ajouter le terme de correction de tension ($u_{corr}$) audit modèle de tension de la machine à courant alternatif pour stabiliser ladite estimation de flux du stator ($\hat{\psi}_s$);
   définir un premier terme d'erreur d'adaptation de résistance ($P_{err}$) comme produit scalaire entre une négation dudit terme de correction de tension ($-u_{corr}$) et ledit vecteur de courant de stator ($i_s$) ($P_{err} = -u_{corr} \cdot i_s$) ;
   définir un second terme d'erreur d'adaptation de résistance ($Q_{err}$) comme produit vectoriel entre la négation dudit terme de correction de tension ($-u_{corr}$) et ledit vecteur de courant de stator ($i_s$) ($Q_{err} = -u_{corr} \times i_s$) ;
   définir une limite de fréquence ($\omega_{pq,lim}$);

déterminer une estimation de la résistance du stator ($\hat{R}_s$) à l'aide dudit premier terme d'erreur d'adaptation de résistance ($P_{err}$) dans un mécanisme d'adaptation PI lorsque la valeur absolue de la fréquence électrique ($\omega_s$) de la machine à courant alternatif est inférieure à ladite limite de fréquence ($\omega_{pq,lim}$);

et déterminer une estimation de la résistance du stator ($\hat{R}_s$) à l'aide dudit second terme d'erreur d'adaptation de résistance ($Q_{err}$) dans un mécanisme d'adaptation PI lorsque la valeur absolue de ladite fréquence électrique ($\omega_s$) de la machine à courant alternatif est supérieure ou égale à ladite limite de fréquence ($\omega_{pq,lim}$).

2. Procédé selon la revendication 1, **caractérisé en ce que** la détermination de la première estimation de l'amplitude du flux du rotor ($\hat{\psi}_{Rc}$), qui est indépendante des résistances de la machine à courant alternatif, comprend une étape en connexion avec une machine à synchronisation permanente, où la première estimation de l'amplitude du flux du rotor est fixée pour être le flux ($\hat{\psi}_{R,pm}$) d'un aimant permanent de la machine synchrone.

3. Procédé selon la revendication 1, **caractérisé en ce que** la détermination de la première estimation de l'amplitude du flux du rotor ($\hat{\psi}_{Rc}$), qui est indépendante des résistances de la machine à courant alternatif, comprend une étape dans laquelle la première estimation de l'amplitude du flux du rotor est calculée à l'aide d'un modèle de courant de la machine.

4. Procédé selon les revendications 1, 2 ou 3, **caractérisé en ce qu'**une direction ($\gamma$) du vecteur de gain d'accord ($K_c$) est sélectionnée en se basant sur une estimation de fréquence électrique ($\hat{\omega}_s$) de la machine de telle sorte que :

$$\gamma = \begin{cases} \gamma_{max}\, \mathrm{sgn}(\hat{\omega}_s) \cdot \left(1 - \dfrac{|\hat{\omega}_s|}{\omega_N}\right), & |\hat{\omega}_s| \le \omega_N \\ 0, & |\hat{\omega}_s| > \omega_N \end{cases},$$

où $\omega_N$ est la fréquence électrique nominale de la machine, et

$$\begin{cases} \gamma_{max} > 40^o,\ \omega_s \hat{i}_{sq} < 0 \\ \gamma_{max} < 40^o,\ \omega_s \hat{i}_{sq} \ge 0 \end{cases},$$

où $\hat{i}_{sq}$ est une estimation d'une composante en quadrature de courant de stator.

FIG 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **I.-J. HA ; S.-H. LEE.** An Online Identification method for both Stator and Rotor Resistances of Induction Motors without Rotational Transducers. *IEEE Transactions on Industrial Electronics,* August 2000, vol. 47 (4), 842-853
- **V. VASIC ; S N. VUKOSAVIC ; E. LEVI.** A stator resistance estimation scheme for speed sensorless rotor flux oriented induction motor drives. *IEEE Trans. Energy Conversion,* December 2003, vol. 18 (4

- **NOVOTNY D. W. ; LIPO T. A.** Vector Control and Dynamics of AC Drives. Oxford University Press, 1997
- Flux estimators for speed-sensorfess induction motor drives. **HINKKANEN M.** Ph.D. thesis, Dept. Elect. Commun. Eng. Helsinki University of Technology, 2004